# EUROPÄISCHE PATENTSCHRIFT

(11) **EP 1 174 310 B1**
(45) Veröffentlichungstag und Bekanntmachung des Hinweises auf die Patenterteilung: **19.10.2005**
(21) Anmeldenummer: 00202577.3
(22) Anmeldetag: 18.07.2000
(51) Int. Cl.: B60R 16/02

(54) **Elektrischer Strom-und Signalleiter**
Electric current and signal conductor
Conducteur de courant électrique et de signaux

(43) Veröffentlichungstag der Anmeldung: 23.01.2002
(73) Patentinhaber: Delphi Technologies, Inc., Troy, MI 48007 (US)
(72) Erfinder: Neumann, Ludwig, 15542 Werder (DE); Zischka, Helmut, 71287 Weissach (DE)
(74) Vertreter: Manitz, Finsterwald & Partner GbR

(56) Entgegenhaltungen:
- EP-A- 0 283 012
- EP-A- 0 595 001
- DE-A- 4 441 268
- US-A- 3 697 767
- PATENT ABSTRACTS OF JAPAN vol. 008, no. 064 (M-285), 27. März 1984 (1984-03-27) & JP 58 214440 A (NISSAN JIDOSHA KK), 13. Dezember 1983 (1983-12-13)

## Beschreibung

Die Erfindung betrifft einen elektrischen Strom- und Signalleiter mit den Merkmalen des Oberbegriff des Patentanspruch 1. Insbesondere im Kraftfahrzeugbau handelt es sich dabei insbesondere um aus mehreren Kabeln (Einzeladern) gebildete Kabelbaeume, deren Kabel in einer bestimmten Weise gebuendelt werden. Beispielhaft ist es verbreitet, sowohl Energieleitungen fuer den elektrischen Strom, als auch elektrische Signalleitungen miteinander zu einem kompakten Kabelbaum zu verdrillen (Power-CAN).

Die dezentrale Steuerungstechnik (CAN -Technik = Controller Area Network) hat zwar grundsaetzlich den Verkabelungsaufwand an Bord von Fahrzeugen reduziert, weil nicht jede Baueinheit mit einer Zentraleinheit verbunden werden muss. Allerdings erfordert CAN eine ungehemmte Kommunikation einzelner Baugruppen miteinander sowie mit einer zentralen Prozessoreinheit. Mit anderen Worten ist es erforderlich, bestimmte Baueinheiten (beispielsweise alle Tuer- Fenster-, Schiebedach- oder Verdeckschliessvorrichtungen) untereinander zu vernetzen, und diese Einheit mindestens jeweils einmal mit der Zentraleinheit zu verbinden. Ein oder mehrere lokale Prozessoren, vorzugsweise im Bereich einer oder mehrerer der Schliessvorrichtungen, ersetzen somit Funktionen von zentralen Prozessoren und uebernehmen folglich eine dezentrale Steuerungsfunktion.

Den Steuersignalen sowie den die Steuersignale fuehrenden elektrischen Adern faellt eine besondere Rolle zu, weil diese unmittelbar die Ansteuerungssignale fuer eine bestimmte der zusammengefassten Baugruppen fuehrt. Eine Stoerung oder Verfremdung der Ansteuersignale kann die Zuordnung zu einer bestimmten elektrischen Vorrichtung erschweren oder sogar unterbinden. Folglich kann die fehlerfreie Funktion unter diesen Umstaenden nicht garantiert werden. Dieser Zusammenhang ist insbesondere unter dem Aspekt der EMV (Elektro-Magnetische-Verträglichkeit) bedeutsam, weil elektromagnetische Feldeinstreuungen die genannten Steuersignale derart beeinflussen und verfremden können, dass die gewünschte Baueinheit die gegebenen Steuersignale nicht ausführt.

Bei bekannten Kabelbäumen sind nun Aussagen hinsichtlich der EMV lediglich auf statistischer Basis möglich. Jedenfalls kann im Rahmen einer Großserie keine genaue Aussage über das EMV-Verhalten eines bestimmten Kabelbaumes gemacht werden. Besonders problematisch ist die Situation nach dem Einbau in ein Fahrzeug.

Aus der EP-A-0 283 012 ist eine Kabelanordnung bekannt, bei der sich zwei lang gestreckte, streifenförmige elektrische Leitungen zur Stromversorgung parallel zueinander erstrecken. Der Abstand zwischen den beiden aufeinander liegenden Stromversorgungsleitungen ist möglichst gering gehalten und zwei Signalleitungen sind seitlich von diesen etwa auf mittlerer Höhe zwischen den beiden Stromversorgungsleitungen angeordnet.

Aus der US-A-3,697,767 ist ein Kabel bekannt, in welchem eine Stromversorgungsleitung neben einer Vielzahl von parallel verlaufenden Signalleitem angeordnet ist, welche im Vergleich zur Stromversorgungsleitung einen kleinen Durchmesser besitzen.

Aus der JP 58214440 A ist eine Anordnung bekannt, bei der ein Kabelbaum für elektrische Geräte, welche große Ströme benötigen, von einem Kabelbaum für elektrische Geräte, welche schwache Ströme benötigen, durch einen Isolator getrennt ist. Die beiden Kabelbäume sind parallel zueinander angeordnet und durch den Isolator mindestens 5 cm voneinan der beabstandet. Die Anordnung verhindert, dass Rauschen von einem Kabelbaum in den anderen induziert wird.

Aus der EP-A-0 595 001 ist eine Flachbandkabelanordnung mit zwei Leiterpaaren für zwei getrennte Stromkreise bekannt. Ein Leiter eines Paares wird in zwei Leiter aufgeteilt und die Leiter werden insgesamt symmetrisch und parallel zueinander angeordnet, was eine kapazitive und induktive Entkopplung der beiden Stromkreise ermöglicht.

Aus der DE 44 41 268 A ist eine Mehrfachleitung für Gleich- und Wechselspannungen nach dem Oberbegriff des Anspruchs 1 bekannt, wobei die beiden Kreise für die Stromversorgung einen Leiter gemeinsam haben. Die Leiter besitzen einen flachen Querschnitt, wobei der gemeinsame Leiter einen größeren Querschnitt aufweist und eine Außenseite der Flachleiteranordnung bildet, auf der ein für Steuerzwecke vorgesehenes Bussystem aufgebracht ist.

Aufgabe der vorliegenden Erfindung ist es, einen insgesamt möglichst flachen Leiter bereitzustellen, der imstande ist, auch große Ströme zu leiten, und besonders für den Einbau in einem Fahrzeug, beispielsweise im Fahrzeughimmel, geeignet ist.

Diese Aufgabe wird ausgehend vom Oberbegriff des Anspruchs 1 erfindungsgemäß durch die kennzeichnenden Merkmale des Anspruchs 1 gelöst.

Eine besonders wirksame Abschirmung lässt sich erreichen, wenn die elektrische Ader mit negativer Polung (Masse) mit der elektrischen Ader zur Signalleitung in einer parallel zur Dickenrichtung des Leiters liegenden Ebene liegt.

Es sind wenigstens zwei elektrische Adern zumindest teilweise parallel zueinander vorgesehen. Die Herstellung des kompakten, grundsätzlich mehrschichtigen FPC erfolgt auf dem Wege eines Rolle-zu-Rolle-Verfahrens, was Handhabungsvorteile und Herstellungsvorteile erbringt.

In dem Bereich, in dem keine elektrische Ader zur Stromleitung mit einer elektrischen Ader zur Signalleitung in einer parallel zur Dickenrichtung des Leiters liegenden Ebene liegt, wobei die elektrische Ader zur Signalleitung und wenigstens eine elektrische Ader zur Stromleitung innerhalb dieses Bereiches ein unterschiedliches Niveau in Bezug auf die Dickenrichtung des Leiters aufweisen, ist die elektrische Stromader im Vergleich zu der Signalader nicht nur in y-Richtung (quer zur z-Richtung) sondern auch in z-Koordinatenrichtung (Dickenrichtung des Leiters) getrennt.

Gemäß einer bevorzugten Ausführungsform kann es vorgesehen sein, dass die beiden unterschiedlichen elektrischen Adern in wenigstens einem Bereich nicht in einer zur Dickenrichtung des Leiters parallelen Ebene liegen und in Bezug auf die Dickenrichtung des Leiters auf einem übereinstimmenden Niveau liegen. Auf diese Weise wird die Dicke des FPC-Leiters in z-Richtung reduziert und der erforderliche Einbauraum verringert.

Für den Ausbau der Leistungsfähigkeit kann der Strom und Signalleiter mehrere elektrische Adern für die Signalübertragung aufweisen, die in einer y-Richtung nebeneinander vorgesehen sind.

Dadurch, dass jeweils zwei elektrische Stromadern mit positiver Polung und jeweils zwei elektrische Stromadern mit negativer Polung vorgesehen sind, wobei die Stromadern mit gleicher Polung jeweils zumindest bereichsweise in einer gemeinsamen, parallel zur Dickenrichtung des Leiters liegenden Ebene liegen, wird es ermöglicht, den Stromfluss auf zwei elektrische Adern zu verteilen, was für die die Übertragung größerer Ströme vorteilhaft ist. Gleichzeitig ist es möglich, die beiden elektrischen Adern auf den beiden Seiten beispielsweise mittels Laserprozessen, Stanzen oder Drucksteckverbindern (splice clip) elektrisch miteinander zu verbinden.

Durchgangsloecher durch den Leiter erlauben eine Befestigung, beispielsweise an Fahrzeugbauteilen, wie der Fahrzeugzelle (Body), der Instrumententafel, sowie Tuer- oder Dachhimmelverkleidungen oder aehnlichem.

Schliesslich koennen SMD-Bauteile (Surface-Mounted-Devices) unterschiedlichster Art an jeder beliebigen Oberflaechenstelle des Leiters angeordnet werden, und die gewuenschten elektrischen Adern kontaktieren. Dies ermoeglicht beispielsweise einen Abgleich der jeweiligen Leitung an das Bordnetz (Wellenwiderstand).

Ein besonders stabiler mechanischer Aufbau wird mittels symmetrischer Anordnung der elektrischen Adern erreicht.

Vorteilhafte Ausfuehrungsformen gehen aus Unteranspruechen im Zusammenhang mit der Beschreibung und der Zeichnung hervor. In der Zeichnung zeigt:
Fig. 1 A: schematisiert sowie stark vergroessert ein Strom- und Signalleiter im Schnitt;
Fig. 1 B,C: derselbe Strom- und Signalleiter wie in Figur 1 A im Schnitt an anderer Stelle mit zwei alternativen Ausfuehrungen (B und C) fuer die Aderanordnung;
Fig. 2 A: wie in Figur 1 ein alternativer Strom- und Signalleiter;
Fig. 2 B,C: derselbe Strom- und Signalleiter wie in Figur 2 A im Schnitt an anderer Stelle mit zwei alternativen Ausfuehrungen (B und C) fuer die Aderanordnung;
Die in den Figuren 1 A bis 2C dargestellten Leiter sind keine Ausführungsbeispiele der vorliegenden Erfindung.
Fig. 3: schematisiert sowie stark vergroessert eine Draufsicht auf eine weitere Ausfuehrungsform des Strom- und Signalleiters;
Fig. 4: einen Schnitt entlang der Linie IV-IV in Figur 3:
Fig. 5: einen Schnitt entlang der Linie V-V in Figur 3, und
Fig. 6: ein schematisierter sowie stark vergroesserter Laengsschnitt entlang der Linie VI-VI in Fig. 4.

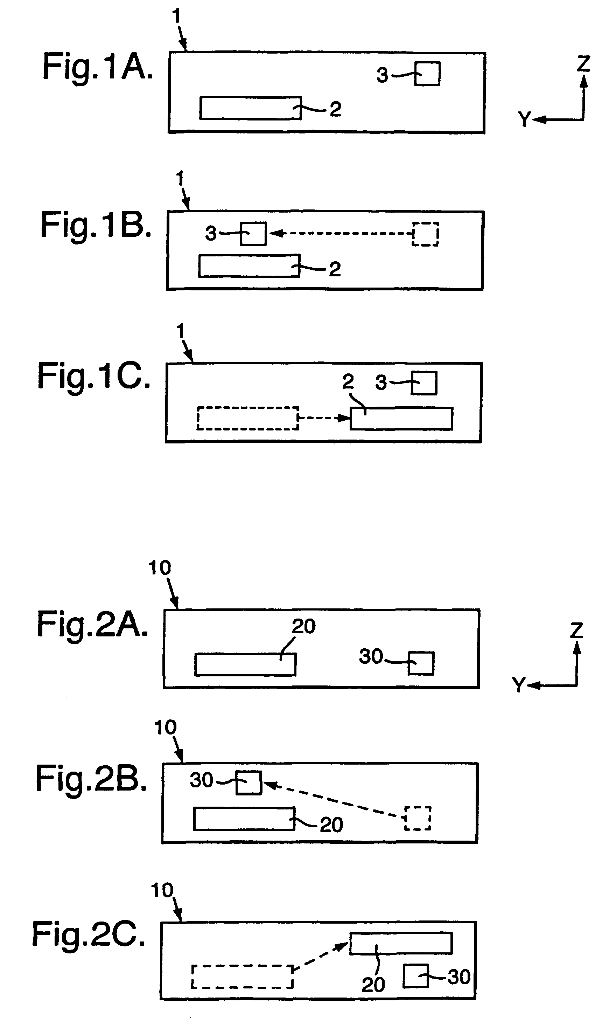

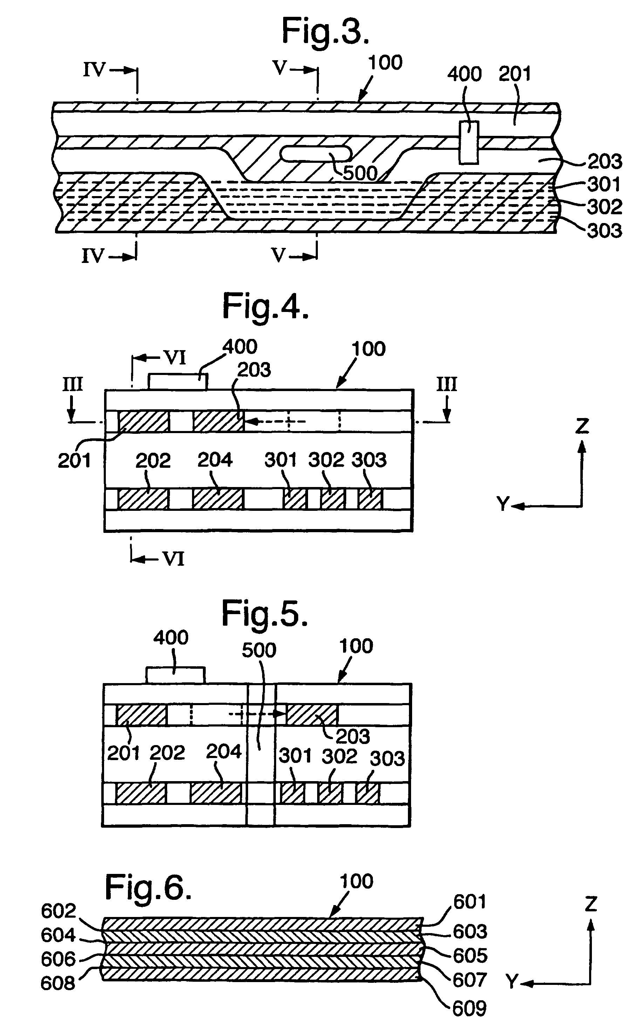

Allen Figuren ist eine starke Vergroesserung des Strom- und Signalleiters 1,10,100 gemeinsam, welcher als kompaktes sowie sehr flaches FPC-Bauteil aufgebaut ist (Flexible Printed Circuit). Die Dicke in Richtung der z-Koordinate kann dabei wenige Bruchteile eines Millimeters betragen. Der FPC weist grundsaetzlich eine Sandwichstruktur aus mehreren duennen Materiallagen 601 bis 609 auf, welche der besseren Uebersichtlichkeit wegen in den Figuren 1 bis 5 nicht dargestellt sind. Einzelheiten hierzu sind beispielhaft der Figur 6 zu entnehmen. Die Figur 1 zeigt einen Strom- und Signalleiter 1 mit einer elektrischen Ader 2 fuer die (Last-) Stromversorgung eines elektrischen Aggregates, beispielsweise eines elektrischen Fensterhebers fuer ein Kraftfahrzeug und mit einer zweiten elektrischen Ader 3 fuer die Signalleitung (logische Ansteuerung) desselben Aggregates oder einer anderen elektrischen Einrichtung. Wie zu ersehen ist, sind die beiden elektrischen Adern 2,3 in y-Richtung (Breitenkoordinate) nebeneinander sowie auf unterschiedlichen Ebenen in z-Richtung angeordnet. Wie die Figuren 1 B und C zeigen, ist in einem Bereich mit elektromagnetischer Abschirmung jeweils eine der elektrischen Adern 2,3 zumindest ueber eine bestimmte Laenge des Leiters in z-Richtung (Dickenrichtung) fluchtend zu der anderen elektrischen Ader 2,3 vorgesehen. Mit anderen Worten sind die beiden elektrischen Adern 2,3 bei gedachter Projektion in z-Koordinatenrichtung zumindest teilweise deckungsgleich. Fuer die elektromagnetische Abschirmung wird grundsaetzlich die elektrische Ader 2 mit negativer Polung (Masse) herangezogen. Bei der Variante gemaess Fig. 1 B ist dies dadurch gewaehrleistet, dass die Signalader 3 auf demselben z-Niveau verbleibt, aber in y-Richtung oberhalb der Stromader 2 angeordnet wird. Dies ist vorteilhaft, weil die geringe Breite der Signalader 3 eine unproblematische laterale Aderfuehrung erlaubt.

Bei dem Ausfuehrungsbeispiel nach Figur 1C wurde die Stromader 2 in einem Bereich lateral, das heisst seitlich in y-Richtung vesetzt angeordnet, so dass sie in z-Koordinatenrichtung mit der Signalader 3 fluchtet. Der jeweilige Versatz sowie die Ausgangsposition wird in den Figuren mit einem gestrichelten Pfeil verdeutlicht.

Die Figur 2 A zeigt eine andere Ausfuehrungsform eines Leiters 10 wobei in dem Ausgangszustand sowohl die Stromader 20, als auch die Signalader 30 auf demselben Niveau in Dickenrichtung (z-Koordinate) angeordnet sind. Die in z-Richtung fluchtende Anordnung der elektrischen Adern 20,30 kann mittels zweier Alternativen, naemlich durch Versatz der Stromader 20 oder der Signalader 30 jeweils in z- und y-Richtung herbeigefuehrt werden (Fig. 2 B und 2C).

Die Figuren 3 bis 6 zeigen einen Leiter 100 mit insgesamt zwei (Strom)Adern 201, 202 positiver Polung, zwei (Strom)Adern negativer Polung 203,204 und drei (Signal)Adern 301,302,303, welche ueber die Laenge des Leiters 100 weitgehend parallel angeordnet sind. Jeweils mehrfach (hier redundant) vorgesehene Stromadern 201 - 204 derselben Polung dienen dabei der Vergroesserung der Stromtragfaehigkeit und sind vorzugsweise miteinander elektrisch verbunden (beispielsweise mittels Splice-Clips das heisst Duchsteckverbindern). In vereinfachender Weise wurde der mehrlagige Aufbau des FPC-Leiters nicht dargestellt. In einem Abschnitt ist eine der Adern 203 negativer Polung in z-Richtung fluchtend zu den Signalleitungen 301,302,303 angeordnet, wodurch diese gegen elektromagnetische Signaleinstrahlung abgeschirmt werden. Die Draufsicht gemaess Figur 3 zeigt ferner ein SMD-Bauteil 400, welches auf der Oberflaeche angeordnet ist, und die Stromadern 201 - 204 kontaktieren kann. Beispielsweise kann die elektrische Impedanz der Stromleitungen mittels derartiger SMD-Bauteile eingestellt, und an das Bordnetz angepasst werden. Auch die Anpassung an unterschiedliche Bordnetzspannungen (12 V, 24 V oder 42 V-Netz ist dadurch moeglich). Es ist ferner eine Oeffnung 500 ersichtlich, welche der Befestigung des Leiters an Fahrzeugteilen oder dem Fahrzeugbody dient. Der Versatz des Stromleiters 203 gegenueber dem Ausgangszustand (Fig. 4) erfolgt hierbei in y-Richtung (Breitenrichtung), wobei das z-Niveau beibehalten wird. Figur 4 verdeutlicht die Aderanordnung vor - und Figur 5 nach dem Versatz der Stromader 203. Auch die Oeffnung 500 fuer ein mechanisches Befestigungsmittel ist in Figur 5 ersichtlich.

Schliesslich ist in Figur 6 der mehrlagige Aufbau des FPC-Leiters exemplarisch dargestellt. Der FPC umfasst demnach in der folgenden Reihenfolge (Dickenangabe beispielhaft): Deckfolie 601 (25 µm Dicke) - Kleberschicht/folie 602 (15 µm) - Kupferschicht 603 (70 µm) - Kleberschicht 604 (15 µm) - Deck- oder Basisfolie 605 (25 µm) -Kleberschicht 606 (15 µm) - Kupferschicht 607 (70 µm) - Kleberschicht 608 (15 µm) - Deckfolie 609 (25 µm). Selbstverstaendlich koennen in diesem Zusammenhang beliebig viele andere Aderzahlen und Aderanordnungen vorgesehen werden, ohne die Erfindung zu verlassen. Es ist insbesondere auch moeglich, zusaetzliche Folien oder Schichten jeweils unter Zwischenschaltung wenigstens einer Kleberschicht vorzusehen. In diesem Zusammenhang sei schliesslich hinzugefuegt, dass auch das Anordnungsdesign (vgl. Fig. 4 - gegenueberliegende (Strom)Adern 201-204 beispielhaft ist, und grundsaetzlich beliebig abgewandelt werden kann.

Allerdings sind weitgehend symmetrische Querschnitte zu bevorzugen, weil diese einen besonders widerstandfaehigen mechanischen Aufbau haben.

## Patentansprüche

1. Elektrischer Strom- und Signalleiter (100), insbesondere für ein Kraftfahrzeug, mit wenigstens zwei elektrischen Adern (201-204, 301-303), wobei mindestens eine elektrische Ader (201-204) zur Stromleitung und mindestens eine elektrische Ader (301-303) zur Signalleitung zumindest bereichsweise fluchtend in einer gemeinsamen, parallel zur Dickenrichtung (z) des Leiters liegenden Ebene liegen,
**dadurch gekennzeichnet,**
**dass** der elektrische Strom- und Signalleiter (100) als kompaktes sowie flaches FPC-Bauteil ausgebildet ist,
**dass** jeweils zwei elektrische Adern (201, 202) zur Stromleitung mit positiver Polung und jeweils zwei elektrische Adern (203, 204) zur Stromleitung mit negativer Polung vorgesehen sind, wobei die Adern (201, 202; 203, 204) mit gleicher Polung jeweils bereichsweise fluchtend in einer gemeinsamen parallel zur Dickenrichtung (z) des Leiters liegenden Ebene liegen, und
**dass** wenigstens ein Bereich vorgesehen ist, in dem ein Durchgangsloch (500) für eine Befestigung des Leiters an Fahrzeugteilen vorgesehen ist, wobei in diesem Bereich mindestens eine elektrische Ader (203) zur Stromleitung in eine Breitenrichtung (y) des Leiters versetzt ist.

2. Elektrischer Strom- und Signalleiter (100) nach Anspruch 1,
**dadurch gekennzeichnet,**
**dass** er mehrere elektrische Adern (301-303) zur Signalleitung aufweist, die in einer Breitenrichtung (y) des Leiters nebeneinander vorgesehen sind.

3. Elektrischer Strom- und Signalleiter (100) nach einem oder mehreren der vorhergehenden Ansprüche,
**dadurch gekennzeichnet,**
**dass** wenigstens ein Surface-Mounted-Device-Bauteil (400) an einer beliebigen Oberflächenstelle des Leiters angeordnet ist, und wenigstens eine elektrische Ader (201-204, 301-303) kontaktiert.

4. Elektrischer Strom- und Signalleiter (100) nach einem oder mehreren der vorhergehenden Ansprüche,
**dadurch gekennzeichnet,**
**dass** die elektrischen Adern (201-204) symmetrisch angeordnet sind.

## Claims

1. An electrical current and signal conductor (100), in particular for a motor vehicle, comprising at least two electrical wires (201, 204, 301-303), with at least one electrical wire (201-204) for the current conduction and at least one electrical wire (301-303) for the signal conduction lying at least regionally in alignment in a common plane disposed parallel to the thickness direction (z) of the conductor,
**characterized in that**
the electrical current and signal conductor (100) is made as a compact and flat FPC component;
**in that** in each case two electrical wires (201, 202) are provided for the current conduction with a positive polarity and two electrical wires (203, 204) are provided for the current conduction with a negative polarity are provided, with the wires (201, 202; 203, 204) of the same polarity each lying at least regionally in alignment in a common plane disposed parallel to the thickness direction (z) of the conductor; and
**in that** at least one region is provided in which a passage bore (500) for a fastening of the conductor to vehicle parts is provided, with at least one electrical wire (203) for the current conduction being offset in a width direction (y) of the conductor in this region.

2. An electrical current and signal conductor (100) in accordance with claim 1, **characterized in that** it has a plurality of electrical wires (301-303) for the signal conduction which are provided next to one another in a width direction (y) of the conductor.

3. An electrical current and signal conductor (100) in accordance with one or more of the preceding claims, **characterized in that** at least one surface mounted device component (400) is arranged at any desired surface position of the conductor and contacts at least one electrical wire (201-204, 301-303).

4. An electrical current and signal conductor (100) in accordance with one or more of the preceding claims, **characterized in that** the electrical wires (201-204) are arranged symmetrically.

## Revendications

1. Conducteur électrique de courant et de signaux (100), notamment pour un véhicule automobile, comprenant au moins deux brins électriques (201 - 204, 301 - 303), dans lequel au moins un brin électrique (201 - 204) pour la conduction de courant et au moins un brin électrique (301 - 303) pour la conduction de signaux se situent du moins partiellement alignés dans un plan commun parallèle à la direction de l'épaisseur (z) du conducteur,
**caractérisé en ce que**
le conducteur électrique de courant et de signaux (100) est réalisé sous la forme d'un composant FPC compact et plat,
respectivement deux brins électriques (201, 202) pour la conduction de courant à polarisation positive et respectivement deux brins électriques (203, 204) pour la conduction de courant à polarisation négative sont prévus, les brins (201, 202 ; 203, 204) à polarisation identique se situant respectivement en partie alignés dans un plan commun parallèle à la direction de l'épaisseur (z) du conducteur, et
au moins une zone munie d'un trou de passage (500) pour une fixation du conducteur à des éléments d'un véhicule est prévue dans cette zone, au moins un brin électrique (203) pour la conduction de courant étant décalé dans une direction de la largeur (y) du conducteur.

2. Conducteur électrique de courant et de signaux (100) selon la revendication 1,
**caractérisé en ce qu'**il présente plusieurs brins électriques (301 - 303) pour la conduction de signaux, qui sont prévus juxtaposés dans une direction de la largeur (y) du conducteur.

3. Conducteur électrique de courant et de signaux (100) selon l'une ou plusieurs des revendications précédentes,
**caractérisé en ce qu'**au moins un composant de type dispositif porté par une surface (400) est disposé à un endroit quelconque de la surface du conducteur et met en contact au moins un brin électrique (201 - 204, 301 - 303).

4. Conducteur électrique de courant et de signaux (100) selon l'une ou plusieurs des revendications précédentes,
**caractérisé en ce que** les brins électriques (201 - 204) sont disposés symétriquement.
